# EUROPÄISCHE PATENTSCHRIFT

(11) **EP 1 605 238 B1**
(45) Veröffentlichungstag und Bekanntmachung des Hinweises auf die Patenterteilung: **04.01.2012**
(21) Anmeldenummer: 05009634.6
(22) Anmeldetag: 03.05.2005
(51) Int. Cl.: G01K 17/06

(54) **Elektronischer Heizkostenverteiler**
Electronical heating-cost distributor
Distributeur électronique de frais de chauffage

(30) Priorität: 14.05.2004 DE 102004023989
(43) Veröffentlichungstag der Anmeldung: 14.12.2005
(73) Patentinhaber: Hydrometer Electronic GmbH, 90451 Nürnberg (DE)
(72) Erfinder: Werner, Wolfgang, 90556 Cadolzburg/Wachendorf (DE); Sebald, Marc, 91236 Alfeld (DE); Becke, Gerhard, 91301 Forchheim (DE)
(74) Vertreter: Diehl Patentabteilung

(56) Entgegenhaltungen:
- DE-C1- 10 146 207
- DE-U1- 20 319 708
- DE-U1- 29 515 173

## Beschreibung

Die Erfindung betrifft einen elektronischen Heizkostenverteiler mit einer in einem Gehäuse angeordneten Leiterplatte gemäß dem Oberbegriff des Patentanspruchs 1.

Bei einem zur Messung der von einem Heizkörper abgegebenen Wärmemenge dienenden elektronischen Heizkostenverteiler werden im Gegensatz zu einem Verdunstungsheizkostenverteiler üblicherweise zwei Temperatursensoren eingesetzt. Dabei dient ein Sensor zur Ermittlung der Oberflächentemperatur eines Heizkörpers und der weitere Sensor zur Ermittlung der Raumtemperatur.

Der Heizkostenverteiler weist als Bestandteil dessen Gehäuses in der Regel ein aus einem wärmeleitfähigen Material hergestelltes Rückenteil auf, welches am Heizkörper direkt befestigt und thermisch leitend mit einer Heizkörperoberfläche verbunden ist. Auf dem Rückenteil ist ein z.B. aus Kunststoff gefertigtes Gehäusevorderteil aufgesetzt, das in Verbindung mit dem Rückenteil ein geschlossenes Gehäuse des elektronischen Heizkostenverteilers darstellt. Im Inneren des Gehäuses ist eine Leiterplatte angeordnet, welche zusätzlich zu weiteren Bauelementen oder Komponenten die Temperatursensoren zum Messen der Heizkörpertemperatur einerseits und der Raumlufttemperatur andererseits trägt.

Aus der DE 199 38 812 A1 ist ein solcher elektronischer Heizkostenverteiler mit zwei auf einer Leiterplatte befindlichen Temperatursensoren bekannt. Die Leiterplatte ist in Gehäuselängsrichtung schräg im Gehäuse platziert, wobei der Heizkörpertemperatursensor und der Raumlufttemperartursensor auf gegenüberliegenden Plattenseiten der Leiterplatte plaziert sind. Um den Temperatursensor zur Ermittlung der Oberflächentemperatur des Heizkörpers thermisch leitend mit dessen Oberfläche zu verbinden, ist die Leiterplatte im Gehäuse um eine Achse verschwenkbar gelagert. Eine Feder drückt diejenige Stelle der Leiterplatte, an der sich der Temperatursensor zur Ermittlung der Heizkörperoberflächentemperatur befindet, gegen das aus einem wärmeleitfähigen Material hergestellte Rückenteil. Dadurch wird einerseits der Temperatursensor mechanisch belastet und andererseits verliert die Feder, die die Leiterplatte gegen das Rückenteil drückt, im Laufe der Zeit an Federkraft, so dass der thermisch leitende Kontakt zwischen dem Temperatursensor und dem Rückenteil nicht dauerhaft gewährt ist.

Da das Rückenteil des bekannten elektrischen Heizkostenverteilers aus einem wärmeleitfähigen Material hergestellt ist, erfasst der an das Rückenteil gedrückte Temperatursensor nicht nur die Temperatur in der unmittelbaren Umgebung des Temperatursensors, sondern auch die das wärmeleitfähige Rückenteil umgebende Temperatur. Im Gegensatz dazu erfasst der an die Gehäusevorderseite gedrückte Raumlufttemperatursensor aufgrund der geringen Wärmeleitfähigkeit des üblicherweise aus einem Kunststoff bestehenden Vorderteils lediglich die Temperatur in unmittelbarer Umgebung des Raumlufttemperatursensors.

Sollen nun die auf der Leiterplatte anzuordnenden Temperatursensoren als SMD (surface mount device)-Bauelemente ausgeführt sein, um diese automatisch auf der Leiterplatte zu platzieren, zu fixieren und zu verlöten, ist es bei den bekannten Heizkostenverteilem erforderlich, die Leiterplatte von beiden Plattenseiten mittels eines entsprechenden Automaten zu bestücken. Dies resultiert darin, dass der Bestückungs- und Lötprozess mindestens zweimal abwechselnd hintereinander durchgeführt werden muss, was den Herstellungsprozess für die Fertigstellung der Leiterplatte entsprechend verlängert. Außerdem wirkt sich ein zweiter Automatenbestückungsprozess auf der an einer Leiterplatte noch nicht bestückten Seite qualitätsschädigend aus, da die beim ersten Automatenbestückungsprozess verarbeiteten Bauelemente im zweiten Automatenbestückungsprozess aus ihren Klebe-und Lötverbindungen gelöst werden können.

Der Erfindung liegt die Aufgabe zugrunde, einen elektronischen Heizkostenverteiler anzugeben, mit dem unter Vermeidung der genannten Nachteile eine zuverlässige Messung sowohl der Heizkörper- als auch Raumlufttemperatur ohne mechanische Belastung der Temperatursensoren ermöglicht wird. Auch sollen für einen schnellen und effizienten Herstellungsprozess einerseits und zur Verringerung der Größe der Fläche von der für den Heizkostenverteiler verwendeten Leiterplatte andererseits SMD-Bauelemente (automatenbestückbare Bauelemente) und andere automatenbestückbare Komponenten verwendet werden können, die automatisch auf der Leiterplatte platziert, fixiert und mit auf der Leiterplatte verlaufenden Leiterbahnen elektrisch leitend verbunden werden können.

Diese Aufgabe wird erfindungsgemäß gelöst durch die Merkmale des Anspruchs 1. Dazu ist zumindest einem der beiden Temperatursensoren ein wärmeleitfähiges und elastisch verformbares Element zugeordnet. Mit diesem ist der entsprechende Temperatursensor über ein elektrisch leitfähiges Element thermisch leitend verbunden. Dieses elektrisch leitfähige Element kann durch eine auf der Leiterplatte verlaufende Leiterbahn, durch eine Durchkontaktierung von einer Seite der Leiterplatte zur anderen Seite der Leiterplatte oder auch durch eine Kombination aus beidem gebildet sein.

Der elektronische Heizkostenverteiler weist eine in einem Gehäuse angeordnete Leiterplatte mit einer ersten Plattenseite (Bestückungsseite) und einer zweiten Plattenseite auf. Auf der ersten Plattenseite vorzugsweise sind sowohl der Heizkörpertemperatursensor als auch ein Raumlufttemperatursensor sowie ein erstes dem Heizkörpertemperatursensor zugeordnetes wärmeleitfähiges und elastisch verformbares Element angeordnet. Der Heizkörpertemperatursensor und der Raumlufttemperatursensor sind an gegenüberliegenden Plattenenden der ersten Plattenseite vorgesehen. Ein zweites wärmeleitfähiges und elastisch verformbares Element ist in bevorzugter Ausgestaltung der Erfindung auf einer Gehäuseinnenseite angeordnet und mit dem Raumlufttemperatursensor über eine von der ersten auf die zweite Plattenseite führende, elektrisch und/oder thermisch leitende Verbindung thermisch leitend verbunden.

Zwar ist es aus der DE 101 46 207 C1 bekannt, einen Raumlufttemperatursensor über ein wärmeleitfähiges Element mit dem dem Heizkörper abgewandten Gehäusevorderteil des Heizkostenverteilers thermisch leitend zu verbinden. Allerdings weist dieser bekannte Heizkostenverteiler keinen Heizkörpertemperatursensor auf.

Die Leiterplatte des erfindungsgemäßen Heizkostenverteilers weist eine Bestückungsseite auf, die der Heizkörperseite zugewandt ist. Demzufolge sind auch der auf der Leiterplatte angeordnete Heizkörpertemperatursensor und der auf der Leiterplatte angeordnete Raumlufttemperatursensor der Heizkörperseite zugewandt. Zur Messung einer raumluftseitigen und einer heizkörperseitigen Temperatur ist es von Vorteil, nicht nur die Temperatur in unmittelbarer Umgebung des jeweiligen Temperatursensors zu erfassen, sondern dem jeweiligen Temparatursensor einen wärmeleitfähigen Körper größeren Ausmaßes zuzuordnen, infolgedessen thermisch leitender Verbindung mit dem Temperatursensor die den wärmeleitfähigen Körper umgebende Temperatur zuverlässig erfasst wird. Dem Heizkörpertemperatursensor ist daher ein (erstes) wärmeleitfähiges und elastisch verformbares Element derart zugeordnet, das dieses einerseits den Heizkörpertemperatursensor und andererseits eine heizkörperseitige Gehäuseinnenwand des Gehäuse des Heizkostenverteilers zur Ermittlung der Heizkörperoberflächentemperatur kontaktiert.

Die Leiterplatte ist vorteilhafterweise nur einseitig mit automatenbestückbaren Bauelementen versehen. Dadurch muss ein Automatenbestückungsprozess nur ein einziges Mal durchgeführt werden, so dass in Folge eines durch einen zweiten Automatenbestückungsprozess auftretende Probleme zuverlässig vermieden sind.

Zur Messung der Raumlufttemperatur ist auch dem Raumlufttemperatursensor ein (zweites) wärmeleitfähiges und elastisch verformbares Element zugeordnet. Das zweite Element ist auf der der Heizkörperseite abgewandten Gehäuseinnenseite angeordnet und kontaktiert sowohl die Gehäuseinnenseite als auch die der Gehäuseinnenseite zugewandte zweite Plattenseite. Zweckmäßigerweise ist der Raumlufttemperatursensor über eine von der ersten auf die zweite Plattenseite thermisch und/oder elektrisch leitende Verbindung mit dem zweiten, wärmeleitfähigen und elastisch verformbaren Element verbunden. Die thermische bzw. elektrisch leitende Verbindung ist vorzugsweise als Durchkontaktierung ausgeführt, welche den Raumlufttemperatursensor und das zweite Element über eine auf der zweiten Plattenseite verlaufende, großflächig ausgeführte Leiterbahn kontaktiert.

Um die Größe der Fläche der Leiterplatte möglichst gering zu gestalten, werden automatenbestückbare Komponenten und/oder Bauelemente, die erheblich geringere Ausmaße als nicht-automatenbestückbare Bauelemente bzw. Komponenten aufweisen, eingesetzt. Da lediglich eine Plattenseite der Leiterplatte mit automatenbestückbaren Komponenten versehen ist, kann der Herstellungsprozess für die Bestückung der Leiterplatte erheblich beschleunigt werden.

In vorteilhafter Ausgestaltung ist die Leiterplatte im Gehäuse in Gehäuselängsrichtung schräg verlaufend angeordnet. Diese Anordnung ist für die an den gegenüberliegenden Leiterplattenenden vorgesehenen Temperatursensoren dahingehend von Vorteil, dass der Heizkörpertemperatursensor möglichst nahe an einer heizkörperseitigen Gehäuseinnenseite angeordnet ist. Zudem ist auch der Raumlufttemperatursensor möglichst nahe an einer raumluftseitigen Gehäuseinnenseite angeordnet. Ein weiterer Vorteil für die Anordnung beider Temperatursensoren an gegenüberliegenden Plattenenden der Leiterplatte ist die thermische Entkopplung der Temperatursensoren.

Um die thermische Entkopplung des Heizkörpertemperatursensors und des Raumlufttemperatursensors weiter zu verbessern, werden die Temperatursensoren über möglichst lange Leiterbahnen elektrisch leitend mit einer ebenfalls auf der Leiterplatte angeordneten Auswerteeinheit verbunden. Dazu sind diese Leiterbahnen auf der Leiterplatte vorzugsweise mäanderförmig verlaufend ausgeführt.

In weiterer zweckmäßiger Ausgestaltung weist die Leiterplatte wenigstens eine Unterbrechung in Form vorzugsweise einer Durchgangsöffnung von der einen Plattenseite der Leiterplatte auf die gegenüberliegende Plattenseite zur thermischen Entkopplung der Temperatursensoren auf. Vorzugsweise ist die Leiterplatte mit mehreren Durchgangsöffnungen versehen, welche rechteckig, kreisförmig oder quadratisch ausgeführt sein können. Mehrere Durchgangsöffnungen können in der Umgebung der Temperatursensoren an den gegenüberliegenden Plattenenden der Leiterplatte vorgesehen sein.

Um eine Konvektion der vom Heizkörper erwärmten Luft entlang des dem Heizkörper zugewandten Raumlufttemperatursensor und durch die diesen zumindest teilweise umgebenden, in der Leiterplatte vorgesehenen Durchgangsöffnungen zu vermeiden, ist zwischen dem Raumlufttemperatursensor und einer das Gehäuse des elektronischen Heizkostenverteilers heizkörperseitig verschließenden Gehäuserückseite ein thermisch isolierendes Element angeordnet. Um dabei den Raumlufttemperatursensor besonders zuverlässig gegenüber dem Heizkörper thermisch zu isolieren und die auf den Raumlufttemperatursensor einwirkende Wärmeabstrahlung des Heizkörpers möglichst gering zu halten, ist das thermisch isolierende Element im Vergleich zu den Ausmaßen des Raumlufttemperatursensors großflächig ausgeführt ist.

Auch können die erste und die zweite Plattenseite vertauscht sein, so dass die erste Plattenseite der Heizkörperseite abgewandt und der Raumluftseite zugewandt ist. Demzufolge ist dann das dem Heizungstemperatursensor zugeordnete, wärmeleitfähige und elastisch verformbare Element über eine Durchkontaktierung von der Bestückungsseite zu der der Bestückungsseite gegenüberliegenden Plattenseite der Leiterplatte thermisch leitend mit dem Heizkörpertemperatürsensor verbunden.

Nachfolgend wird ein Ausführungsbeispiel der Erfindung anhand einer Zeichnung näher erläutert. Darin zeigen:
- Fig. 1: in perspektivischer Darstellung einen elektronischen Heizkostenverteilers mit teilweise geschnittenem Gehäuse,
- Fig. 2: den elektronischen Heizkostenverteiler nach Fig. 1 in einem Längsschnitt entlang der Linie II-II in Fig. 3,
- Fig. 3: eine Draufsicht auf die von einer Heizkörperseite abgewandte Gehäuseaußenseite eines elektronischen Heizkostenverteilers,
- Fig. 4a: in Draufsicht eine erste Plattenseite einer im Gehäuse des Heizkostenverteilers angeordneten Leiterplatte, und
- Fig. 4b: in Draufsicht die zweite Plattenseite der.Leiterplatte.

Einander entsprechende Teile sind in allen Figuren mit den gleichen Bezugszeichen versehen.

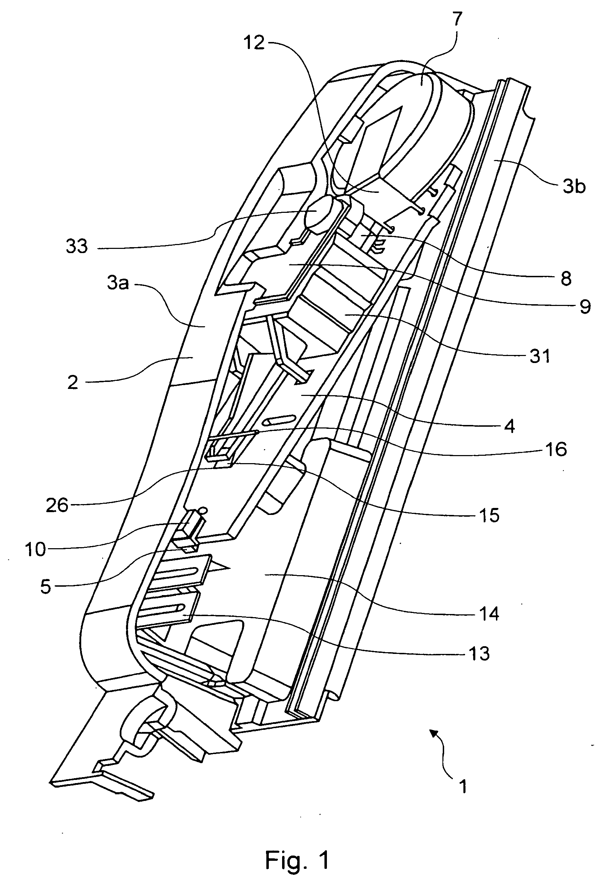

Der elektronische Heizkostenverteiler 1 gemäß Figur 1 umfasst ein Gehäuse 2 mit einer haubenartigen, raumseitigen Gehäusevorderseite 3a und einer diese heizkörperseitig verschließenden Rückseite 3b. Innerhalb des Gehäuses 2 weist der elektronische Heizkostenverteiler 1 eine Leiterplatte oder Platine 4 mit darauf angeordneten Bauelementen und/oder Komponenten in Form elektronischer Bauteile zur Ermittlung einer von einem Heizkörper abgegebene Wärmemenge auf. Zum Auslesen und/oder zur Weiterverarbeitung der vom elektronischen Heizkostenverteiler 1 ermittelten Daten umfasst dieser weiterhin ein LC-Display 9 (liquid crystal display), eine Infrarotschnittstelle 8 und eine Hochfrequenzantenne 13.

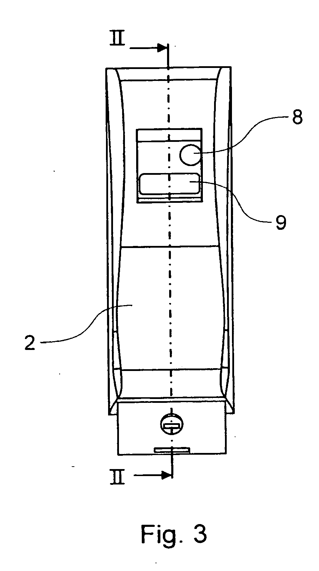

Wie in Fig. 3 gezeigt, ist die Vorderseite 3a des Gehäuses 2 mit Öffnungen für die Infrarotschnittstelle 8 und das LC-Display 9 versehen. Am LC-Display 9 können die vom Heizkostenverteiler 1 ermittelten Daten unmittelbar abgelesen werden. Im Gegensatz dazu können die vom Heizkostenverteiler 1 ermittelten Daten über die Infrarotschnittstelle 8 vor Ort auch elektrisch ausgelesen werden. Die Infrarotschittstelle 8 dient ebenfalls zur kabellosen Ansteuerung des Heizkostenverteilers 1, beispielsweise zur Konfiguration oder Programmierung des elektronischen Heizkostenverteilers 1. Die gehäuseinnenseitig angeordnete Hochfrequenzantenne 13 ist für eine zentrale Datenübertragung und Steuerung eines oder mehrerer elektronischer Heizkostenverteiler 1 in einem Gebäude vorgesehen.

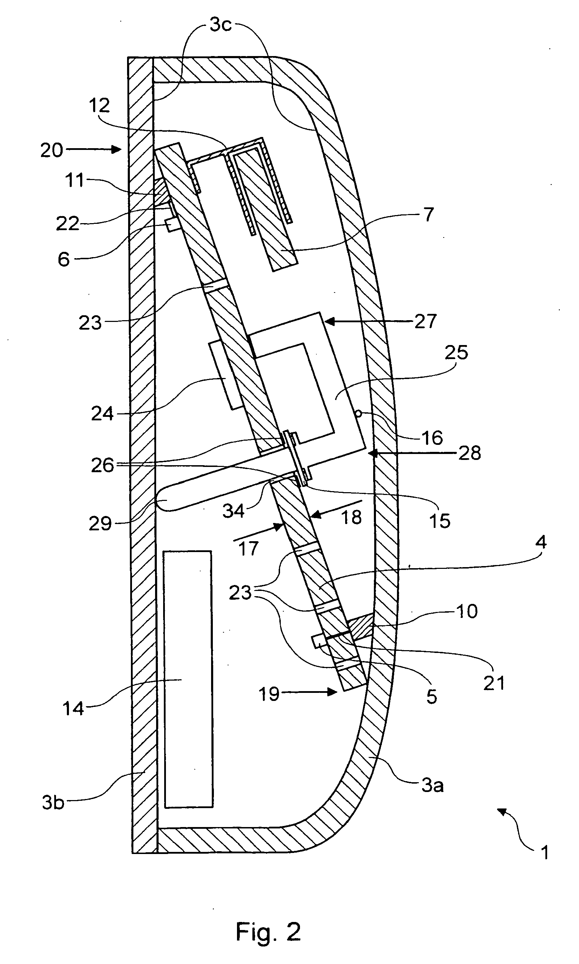

Weiterhin umfasst der elektronische Heizkostenverteiler 1 zwei Temperatursensoren, nämlich einen Heizkörpertemperatursensor 6 und einen Raumlufttemperatursensor 5. Beide Temperatursensoren 5, 6 sind auf derselben Plattenseite 17 der Leiterplatte 4 angeordnet. Fig. 2 zeigt schematisch die Anordnung der Temperatursensoren 5, 6 auf der Leiterplatte 4. Vorzugsweise ist die Leiterplatte 4 schräg in Längsrichtung des Gehäuses 2 angeordnet, so dass der Heizkörpertemperatursensor 6 sich in unmittelbarer Nähe der heizkörperseitigen Rückseite 3b und der Raumlufttemperatursensor 5 sich in unmittelbarer Nähe der der Rückseite 3b abgewandten Gehäuseinnenseite des Gehäuses 2 befindet.

Für einen schnellen sowie effizienten Herstellungsprozess und um die Größe der Fläche der für den elektronischen Heizkostenverteiler 1 verwendeten Leiterplatte 4 vergleichsweise gering zu gestalten, ist es von Vorteil, SMD (surface mount device)-Bauelemente (automatenbestückbare elektronische Bauteile) und/oder andere automatenbestückbare Komponenten zu verwenden, die automatisch auf der Leiterplatte 4 plaziert, fixiert und mit auf dieser verlaufenden Leiterbahnen elektrisch leitend verbunden werden. Vorzugsweise erfolgt die Automatenbestückung der Leiterplatte 4 mit automatenbestückbaren Bauelementen bzw. Komponenten lediglich auf einer einzigen Plattenseite 17 der Leiterplatte 4. Dadurch kann die Fertigungstellung der Leiterplatte 4 erheblich beschleunigt werden.

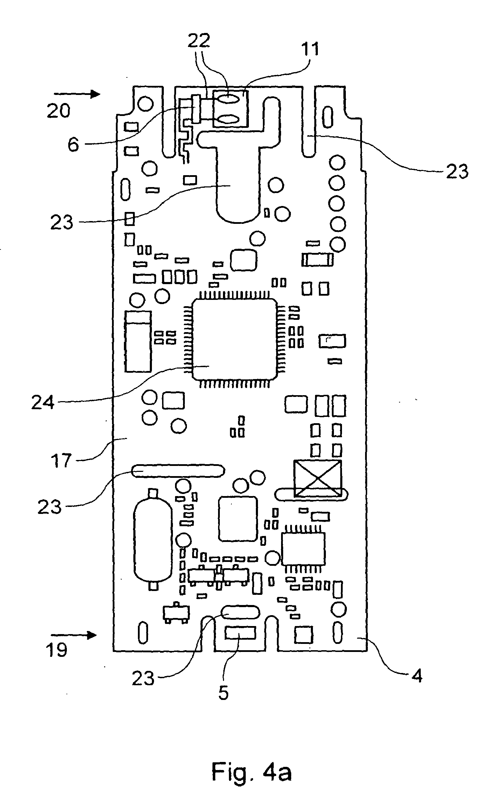

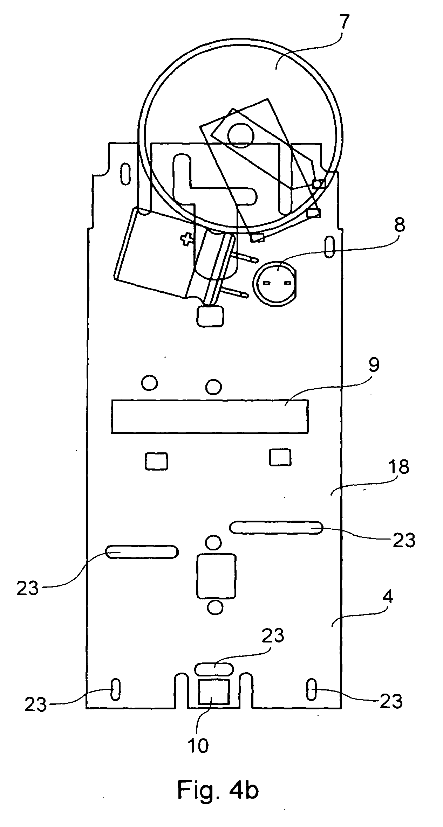

Im Ausführungsbeispiel ist die Plattenseite 17 als Bestückungsseite für automatenbestückbare Bauelemente bzw. Komponenten gewählt. Die Figuren 4a und 4b zeigen die Plattenseiten 17 und 18 der Leiterplatte 4 mit der Plattenseite 17 als Bestückungsseite. Zu den automatenbestückbaren Bauelementen bzw. Komponenten zählen sowohl der Heizkörpertemperatursensor 6 als auch der Raumlufttemperatursensor 5, eine Auswerteeinheit 24 und andere, nicht näher bezeichnete automatenbestückbare Bauelemente bzw. Komponenten.

Die Plattenseite 18 ist mit nicht-automatenbestückbaren Bauelementen bzw. Komponenten versehen, welche nach dem Automatenbestückungsprozess auf der Leiterplatte 4 verarbeitet werden. Zu diesen nicht-automatenbestückbaren Bauelementen bzw. Komponenten zählen einerseits eine auf der der Bestückungsseite 17 gegenüberliegenden Plattenseite 18 der Leiterplatte 4 angeordnete und über einen Abstandshalter 12 fixierte Batterie 7 zur Spannungsversorgung des elektronischen Heizkostenverteilers 1 sowie andererseits die Infrarotschnittstelle 8, die Hochfrequenzantenne 13 und das LC-Display 9. Die auf der Plattenseite 18 der Leiterplatte 4 angeordnete Batterie 7 ist über einen Abstandshalter 12 thermisch von den Temperatursensoren 5, 6 isoliert.

Bei dem in Fig. 2 schematisch im Längsschnitt abgebildeten elektronischen Heizkostenverteilers 1 ist die Bestückungsseite 17 mit sowohl dem Raumluft- 5 als auch dem Heizkörpertemperatursensor 6 der Rückseite 3b zugewandt. Zur Messung einer Heizkörperoberflächentemperatur eines Heizkörpers ist der Heizkörpertemperatursensor 6 thermisch leitend mit einer Heizkörperoberfläche des nicht gezeigten Heizkörpers über die unmittelbar an der Heizkörperoberfläche befestigte Rückseite 3b verbunden. Um den Heizkörpertemperatursensor 6 mechanisch nicht zu belasten, ist nicht der Heizkörpertemperatursensor 6, sondern ein wärmeleitfähiges und elastisch verformbares Element 11 auf die Rückseite 3b gedrückt und mit der Rückseite 3b thermisch leitend verbunden. Das wärmeleitfähige und elastisch verformbare Element 11 ist als automatenbestückbare Komponente gefertigt und ebenfalls auf der Plattenseite 17 der Leiterplatte 4 angeordnet.

Wird die Gehäusevorderseite 3a mit der dort befindlichen Leiterplatte 4 auf die im Heizkörper befestigte Rückseite 3b aufgesetzt, so passt sich das wärmeleitfähige und elastisch verformbare Element 11 an die Form und Ausrichtung der Rückseite 3b elastisch verformend an. Durch Einsatz des wärmeleitfähigen und elastisch verformbaren Elementes 11 wird ein Andrücken des Heizkörpertemperatursensors 6 an die Rückseite 3b überflüssig, denn der Heizkörpertemperatursensor 6 ist mit dem wärmeleitfähigen und elastisch verformbaren Element 11 über wenigstens eine Leiterbahn 22 thermisch leitend verbunden. Zur Optimierung der thermischen Kopplung zwischen dem Heizkörpertemperatursensor 6 und dem wärmeleitfähigen und elastisch verformbaren Element 11 sind der Heizkörpertemperatursensor 6 und das wärmeleitfähige und elastisch verformbare Element 14 unmittelbar nebeneinander auf der Leiterplatte 4 angeordnet und über die vergleichsweise kurze Leiterbahn 22 thermisch verbunden. Des weiteren ist die Verbundstelle zwischen der Leiterbahn 22 und dem Element 11 zur thermischen Kopplung großflächig ausgeführt.

Zur verbesserten Messung einer Raumlufttemperatur ist der Raumlufttemperatursensor 5 im Gegensatz zum Heizkörpertemperatursensor 6, der sich in unmittelbarer Nähe der Rückseite 3b befindet, in größtmöglichem Abstand zu der dem Heizkörper zugewandten Rückseite 3b im Gehäuse 2 angeordnet. Wie in Fig. 2 gezeigt, ist dies dadurch realisiert, dass die im Gehäuse 2 angeordnete, die Temperatursensoren 5, 6 tragende Leiterplatte 4 mit einem Leiterplattenende 20 in unmittelbarer Nähe der Rückseite 3b und mit dem anderen Leiterplattenende 19 in unmittelbarer Nähe einer der Rückseite 3b abgewandten Gehäuseinnenseite des Gehäuses 2 angeordnet ist. Demnach ist die Leiterplatte 4 schräg in Gehäuselängsrichtung angeordnet. Um den Heizkörpertemperatursensor 6 in unmittelbarer Nähe zur Rückseite 3b anzuordnen, ist dieser auf der Plattenseite am Leiterplattenende 20 der Leiterplatte 4 plaziert. Um den Raumlufttemperatursensor 5 in unmittelbarer Nähe der der Rückseite 3b abgewandten Gehäuseinnenseite anzuord--nen, ist der Raumlufttemperatursensor 5 auf der Plattenseite 17 am Leiterplattenende 19 der Leiterplatte 4 plaziert.

Da sich nicht nur der Heizkörpertemperatursensor 6, sondern auch der Raumlufttemperatursensor 5 auf der der Rückseite 3b zugewandten Plattenseite (Bestückungsseite) 17 befinden, ist eine thermisch leitende Verbindung zwischen dem Raumlufttemperatursensor 5 und der der Bestückungsseite 17 abgewandten Gehäuseinnenseite vorgesehen. Dazu umfasst der elektronische Heizkostenverteiler 1 zum einen eine thermisch leitende Verbindung 21 von der Plattenseite 17 zur der Plattenseite 17 gegenüberliegenden und der Rückseite 3b abgewandten Plattenseite 18 der Leiterplatte 4 und zum anderen ein wärmeleitfähiges Element, das zwischen der Plattenseite 18 und der der Rückseite 3b abgewandten Gehäuseinnenseite angeordnet ist. Der Raumlufttemperatursensor 5 ist mit dem wärmeleitfähigen Element 10 über die von der Plattenseite 17 zu der Plattenseite 18 reichende leitende Verbindung 21 thermisch gekoppelt. Dabei ist die thermisch leitende Verbindung 21 beispielsweise als Durchkontaktierung oder als Draht ausgeführt. Das wärmeleitfähige Element 10 ist außerdem elastisch verformbar ausgebildet und passt sich demnach bei Einbringen der Leiterplatte 4 in die Vorderseite 3a des Gehäuses 2 an die Form und Ausrichtung der Leiterplatte 4 elastisch verformend an.

Das wärmeleitfähige und elastisch verformbare Element 10 besteht - wie auch das wärmeleitfähige und elastisch verformbare Element 11 - beispielsweise aus Silikongummi. Über die thermisch leitende Verbindung 21 zwischen dem Raumlufttemperatursensor 5 und dem wärmeleitfähigen und elastisch verformbaren Element 10 erfasst der Raumlufttemperatursensor 5 nicht nur die Temperatur in seiner unmittelbaren Umgebung, sondern auch die Temperatur in der unmittelbaren Umgebung des wärmeleitfähigen und elastisch verformbaren Elements 10, das im Vergleich zum Raumlufttemperatursensor 5 einen Körper mit weitaus größeren Ausmaßen darstellt.

Die Anordnung der Temperatursensoren 5, 6 an den gegenüberliegenden Plattenenden 19 bzw. 20 der Leiterplatte 4 ist auch dahingehend von Vorteil, dass die beiden Temperatursensoren 5 und 6 durch ihren räumlichen Abstand thermisch voneinander entkoppelt sind. Des Weiteren weist die Leiterplatte 4 wenigstens eine Unterbrechung 23 auf, die die thermische Entkopplung beider Temperatursensoren weiter verbessert. Die Unterbrechung stellt eine in der Leiterplatte 4 vorhandene Durchgangsöffnung 23 dar. Zur thermischen Entkopplung beider Temperatursensoren 5, 6 weist die Leiterplatte 4 vorzugsweise mehrere Durchgangsöffnungen 23 auf. Diese liegen in unmittelbarer Nähe des Heizkörpertemperatursensors 6 sowie des Raumlufttemperatursensors 5 und umgeben den jeweiligen Temperatursensor 5 bzw. 6 zumindest teilweise.

Zur thermischen Entkopplung des Raumlufttemperatursensors 5 und des Heizkörpertemperatursensors 6 trägt auch der Verlauf derjenigen auf der Leiterplatte 4 angeordneten Leiterbahnen bei, die beide Temperatursensoren 5, 6 über die Auswerteeinheit 24 elektrisch leitend verbinden. Diese Leiterbahnen sind durch ihren mäanderförmigen Verlauf im Vergleich zu den anderen auf der Leiterplatte 4 verbundenen Leiterbahnen verlängert ausgeführt.

Da der Raumlufttemperatursensor 5 im Ausführungsbeispiel der heizkörperseitigen Rückseite 3b zugewandt ist, ist es vorteilhaft, wenn der elektronische Heizkostenverteiler 1 zur thermischen Entkopplung des Raumlufttemperatursensors 5 und der wärmeleitfähigen Rückseite 3b wenigstens ein thermisch isolierendes Element 14 aufweist, das zwischen der Rückseite 3b und dem Raumlufttemperatursensor 5 angeordnet ist. Das thermisch isolierende Element 14 stellt beispielsweise ein aus Polystyrol hergestelltes Dämmstoffteil dar. Vorzugsweise ist das Dämmstoffteil 14 im Vergleich zu dem Raumlufttemperatursensor 5 großflächig auszubilden, damit nicht nur der Raumlufttemperatursensor 5, sondern auch die in dessen unmittelbarer Nähe auf der Leiterplatte 4 verlaufenden Leiterbahnen gegen direkte Wärmestrahlung und Konvektion der durch den Heizkörper erwärmten Luft abgeschirmt ist.

Des Weiteren umfasst der elektronische Heizkostenverteiler 1 eine Vorrichtung zur Erkennung von mechanischer Manipulation des elektronischen Heizkostenverteilers 1. Die Vorrichtung umfasst ein an der der Rückseite 3 abgewandten Vorderinnenseite 2 des Gehäuses angeordnetes Federelement 16, eine elektrisch leitende Kontaktscheibe 15, zwei auf der Leiterplatte angeordnete elektrisch leitende, aber voneinander elektrisch isolierte Kontaktflächen 26, welche als vergleichsweise großflächig ausgeführte Leiterbahnen ausgebildet sind, und ein auf der Plattenseite 18 der Leiterplatte 4 angeordnetes, die Kontaktscheibe 15 tragendes, rechteckig ausgeführtes und biegeelastisches Element 25. Das biegeelastische Element 25 wird an einem längsseitigen Ende 27 an der Leiterplatte 4 befestigt. An dem dem Ende 27 gegenüberliegenden längsseitigen Ende 28 des biegeelastischen Elements 25 ist die Kontaktscheibe 15 befestigt.

Das innenseitig an der Gehäusevorderseite 3a angeordnete Federelement 16 drückt das nicht auf der Leiterplatte 4 befestigte, längsseitige Ende 28 des biegeelastischen Elements 25 und somit auch die Kontaktscheibe 15 auf die Leiterplatte 4. Die Kontaktscheibe 15 ist derart angeordnet, dass diese die auf der Leiterplatte 4 angeordneten Kontaktflächen 26 bei niedergedrücktem biegeelastischen Element 25 kurz schließt. Die mit den Kontaktflächen 26 elektrisch leitend verbundene Auswerteeinheit 24 registriert einen an den Kontaktflächen 26 anliegenden Kurzschluss oder einen Leerlauf und somit ein Schließen bzw. ein Unterbrechen des Kontaktes zwischen der Kontaktscheibe 15 und den beiden Kontaktflächen 26 durch Herausnehmen der Leiterplatte 4 aus der Vorderseite 3a des Gehäuses 2 oder durch Einsetzen der Leiterplatte 4 in die Vorderseite 2 des Gehäuses.

Die mechanische Manipulation des elektrischen Heizkostenverteilers 1 wird also elektrisch durch Schließen oder Öffnen eines Kontaktes erfasst. Um nicht nur die Demontage der Leiterplatte 4 aus der Vorderseite 3a des Gehäuses 2, sondern auch ein Öffnen des Gehäuses 2 des elektronischen Heizkostenverteilers 1 durch Abnehmen der die Leiterplatte 4 tragenden Vorderseite 3a von der unmittelbar am Heizkörper befestigten Rückseite 3b zu erfassen, weist das biegeelastische Element 25 einen Hebelarm 29 auf, der bei Schließen des Gehäuses 2 durch Aufsetzten des Vorderteils 3a auf die Rückenseite 3b gegen diese gedrückt wird. Sind das biegeelastische Element 25 und der Hebelarm 29 entsprechend Fig. 2 angeordnet, drückt die Rückseite 3b das biegeelastische Element 25 über den Hebelarm 29 von der Leiterplatte 4 weg. Dadurch wird der Kontakt zwischen den zwei Kontaktflächen 26 und der Kontaktscheibe 5 unterbrochen.

Die Auswerteeinheit 24 des elektronischen Heizkostenverteilers 1 erfasst einerseits das Entfernen der die Leiterplatte 4 tragenden Gehäusevorderseite 3a von der Rückseite 3b, indem der Kontakt zwischen den beiden Kontaktflächen 26 geschlossen wird. Andererseits wird die Demontage der Leiterplatte 4 aus der Vorderseite 3a des Gehäuses 2 erfasst, indem der Kontakt zwischen den zwei Kontaktflächen 26 geöffnet wird.

Der elektronische Heizkostenverteiler 1 wird den Anforderungen eines Massenproduktes gerecht, da dieser auf effizientem Wege kostengünstig hergestellt werden kann. Des Weiteren ist der elektronische Heizkostenverteiler 1 ein langlebiges und qualitativ hochwertiges Produkt, da insbesondere für die Funktion eines elektronischen Heizkostenverteilers 1 wichtige elektronische Bauelemente mechanisch nicht belastet werden.

### Bezugszeichenliste

- 1: Elektronischer Heizkostenverteiler
- 2: Gehäuse
- 3a: Gehäusevorderseite
- 3b: Rückseite
- 3c: Gehäuseinnenseite
- 4: Leiterplatte
- 5: Raumlufttemperatursensor
- 6: Heizkörpertemperatursensor
- 7: Batterie
- 8: Infrarotschnittstelle
- 9: LC-Display
- 10,11: wärmeleitfähiges und elastisch verformbares Element
- 12: Abstandhalter
- 13: HF-Antenne
- 14: Dämmstoffteil, thermisch isolierendes Element
- 15: Kontaktscheibe
- 16: Federelement
- 17,18: Plattenseite der Leiterplatte 4
- 19,20: Leiterplattenende
- 21: Durchkontaktierung, thermisch leitende Verbindung
- 22: Leiterbahn
- 23: Unterbrechung, Durchgangsöffnung
- 24: Auswerteeinheit
- 25: Biege elastisches Element
- 26: Kontaktfläche
- 27,28: längsseitiges Ende eines biege elastischen Elements
- 29: Hebelarm
- 30: Heizkörper
- 31: Gehäuseteil für ein Display
- 32: Elektrisch leitende Verbindung
- 33: Schutzkappe für eine Infrarotschnittstelle
- 34: Öffnung in einer Leiterplatte

## Patentansprüche

1. Elektronischer Heizkostenverteiler (1) mit einer in einem Gehäuse (2) angeordneten Leiterplatte (4), auf der an gegenüberliegenden Leiterplattenenden (19,20) ein Raumlufttemperatursensor (5) und ein Heizkörpertemperatursensor (6) vorgesehen sind,
**dadurch gekennzeichnet,**
**dass** die Temperatursensoren (5,6) auf der Bestückungsseite (17) der Leiterplatte (4) angeordnet sind und zumindest einem der beiden Temperatursensoren (5,6) ein wärmeleitfähiges und elastisch verformbares Element (10,11) zugeordnet ist, mit dem der Temperatursensor (5,6) über ein elektrisch leitfähiges Element thermisch leitend verbunden ist.

2. Elektronischer Heizkostenverteiler nach Anspruch 1, bei den das elektrisch leitfähige Element durch eine auf der Leiterplatte (4) verlaufende Leiterbahn (22), eine Durchkontaktierung (21) von einer (17) zu anderen Seite (18) der Leiterplatte oder eine Kombination aus beiden gebildet ist.

3. Elektronischer Heizkostenverteiler nach Anspruch 1 oder 2, bei dem dem Heizkörpertemperatursensor (6) ein erstes, auf der Bestückungsseite (17) angeordnetes, wärmeleitfähiges und elastisch verformbares Element (11) zugeordnet ist, und dem Raumlufttemperatursensor (5) ein zweites an einer Gehäuseinnenseite (3c) angeordnetes, wärmeleitfähiges und elastisch verformbares Element (10) zugeordnet ist, das mit dem Raumlufttemperatursensor (5) über die Durchkontaktierung (21) von der Bestückungsseite (17) zur dieser gegenüberliegenden Plattenseite (18) der Leiterplatte (4) gekoppelt ist.

4. Elektronischer Heizkostenverteiler (1) nach einem der Ansprüche 1 bis 3, bei dem lediglich eine Plattenseite (17) der Leiterplatte (4) mit automatenbestückbaren Komponenten versehen ist.

5. Elektronischer Heizkostenverteiler (1) nach einem der Ansprüche 1 bis 4, bei dem die Leiterplatte (4) im Gehäuse (2) in Gehäuselängsrichtung schräg verlaufend angeordnet ist.

6. Elektronischer Heizkostenverteiler (1) nach einem der Ansprüche 1 bis 5, bei dem das erste und/oder das zweite wärmeleitfähige, elastisch verformbare Element (10 bzw. 11) als Silikongummi ausgebildet ist.

7. Elektronischer Heizkostenverteiler (1) nach Anspruch 2, bei dem die Leiterbahn (22) an einer Verbundstelle zu dem ersten wärmeleitfähigen und elastisch verformbaren Element (11) großflächig ausgeführt ist.

8. Elektronischer Heizkostenverteiler (1) nach Anspruch 2 oder 7, bei dem die Leiterbahn (22) zur thermischen Entkopplung des Heizungstemperatursensors (6) und des Raumlufttemperatursensors (5) zumindest teilweise mäanderförmig verlaufend ausgeführt ist.

9. Elektronischer Heizkostenverteiler (1) nach einem der Ansprüche 1 bis 9, bei dem die Leiterplatte (4) wenigstens eine Unterbrechung (23) zur thermischen Entkopplung des Heizkörpertemperatursensors (6) und des Raumlufttemperatursensors (5) aufweist.

10. Elektronischer Heizkostenverteiler (1) nach einem der Ansprüche 1 bis 9, bei dem zwischen dem Raumlufttemperatursensor (5) und einer das Gehäuse (2) heizkörperseitig verschließenden Gehäuserückseite (3b) ein thermisch isolierendes Element (14) angeordnet ist.

11. Elektronischer Heizkostenverteiler (1) nach Anspruch 10, bei dem das thermisch isolierende Element (14) im Vergleich zu den Ausmaßen des Raumlufttemperatursensors (5) großflächig ausgeführt ist.

## Claims

1. Electronic heating cost distributor (1) having a printed circuit board (4) arranged in a housing (2), a room air temperature sensor (5) and a heating device temperature sensor (6) being provided on said printed circuit board at opposite ends (19, 20) of the printed circuit board,
**characterized**
**in that** the temperature sensors (5, 6) are arranged on the placement side (17) of the printed circuit board (4) and at least one of the two temperature sensors (5, 6) is assigned a thermally conductive and elastically deformable element (10, 11) to which the temperature sensor (5, 6) is thermally conductively connected via an electrically conductive element.

2. Electronic heating cost distributor according to Claim 1, in which the electrically conductive element is formed by a conductor track (22) running on the printed circuit board (4), a plated-through hole (21) from one side (17) to the other side (18) of the printed circuit board or a combination of the two.

3. Electronic heating cost distributor according to Claim 1 or 2, in which the heating device temperature sensor (6) is assigned a first thermally conductive and elastically deformable element (11) arranged on the placement side (17), and the room air temperature sensor (5) is assigned a second thermally conductive and elastically deformable element (10) arranged on an inner side (3c) of the housing, which element is coupled to the room air temperature sensor (5) via the plated-through hole (21) from the placement side (17) to the board side (18) of the printed circuit board (4) that is opposite thereto.

4. Electronic heating cost distributor (1) according to one of Claims 1 to 3, in which only one board side (17) of the printed circuit board (4) is provided with automatic-machine-mountable components.

5. Electronic heating cost distributor (1) according to one of Claims 1 to 4, in which the printed circuit board (4) is arranged in the housing (2) such that it runs obliquely in the longitudinal direction of the housing.

6. Electronic heating cost distributor (1) according to one of Claims 1 to 5, in which the first and/or the second thermally conductive, elastically deformable element (10 and/or 11) is formed as silicone rubber.

7. Electronic heating cost distributor (1) according to Claim 2, in which the conductor track (22) is embodied in large-area fashion at an interconnection location with respect to the first thermally conductive and elastically deformable element (11).

8. Electronic heating cost distributor (1) according to Claim 2 or 7, in which the conductor track (22) is embodied such that it runs at least partially in meandering fashion for the purpose of thermally decoupling the heating temperature sensor (6) and the room air temperature sensor (5).

9. Electronic heating cost distributor (1) according to one of Claims 1 to 9, in which the printed circuit board (4) has at least one interruption (23) for thermally decoupling the heating device temperature sensor (6) and the room air temperature sensor (5).

10. Electronic heating cost distributor (1) according to one of Claims 1 to 9, in which a thermally insulating element (14) is arranged between the room air temperature sensor (5) and a housing rear side (3b) that closes off the housing (2) on the heating device side.

11. Electronic heating cost distributor (1) according to Claim 10, in which the thermally insulating element (14) is embodied in large-area fashion in comparison with the dimensions of the room air temperature sensor (5).

## Revendications

1. Répartiteur électronique (1) de coûts de chauffage présentant une carte de circuit (4) disposée dans un boîtier (2) et sur des extrémités (19, 20) mutuellement opposées de laquelle sont prévues une sonde (5) de température d'air du local et une sonde (6) de température d'un corps de chauffe,
**caractérisé en ce que**
les sondes de température (5, 6) sont disposées sur la face équipée (17) de la carte de circuit (4) et
**en ce qu'**un élément (10, 11) thermiquement conducteur et élastiquement déformable par lequel les sondes de température (5, 6) sont reliées de manière thermiquement conductrice par l'intermédiaire d'un élément électriquement conducteur est associé à au moins l'une des deux sondes de température (5, 6).

2. Répartiteur électronique de coûts de chauffage selon la revendication 1, dans lequel l'élément électriquement conducteur est formé d'une piste conductrice (22) qui s'étend sur la carte de circuit (4), d'un contact (21) qui relie une face (17) de la carte de circuit à son autre face (18) ou d'une combinaison de ces deux éléments.

3. Répartiteur électronique de coûts de chauffage selon les revendications 1 ou 2, dans lequel un premier élément (11) thermiquement conducteur et élastiquement déformable disposé sur la face équipée (17) est associé à la sonde (6) de température de corps de chauffe, un deuxième élément (10) thermiquement conducteur et élastiquement déformable disposé sur un côté intérieur (3c) du boîtier et couplé à la sonde (5) de température d'air du local par l'intermédiaire du contact (21) qui relie la face équipée (17) à la face opposée (18) de la carte de circuit (4) est associé à la sonde (5) de température d'air du local.

4. Répartiteur électronique (1) de coûts de chauffage selon l'une des revendications 1 à 3, dans lequel une seule face (17) de la carte de circuit (4) est dotée de composants aptes à être placés par automate.

5. Répartiteur électronique (1) de coûts de chauffage selon l'une des revendications 1 à 4, dans lequel la carte de circuit (4) est disposée dans le boîtier (2) obliquement par rapport au sens de la longueur du boîtier.

6. Répartiteur électronique (1) de coûts de chauffage selon l'une des revendications 1 à 5, dans lequel le premier et/ou le deuxième élément thermiquement conducteur et élastiquement déformable (10 ou 11) sont formés de caoutchouc au silicone.

7. Répartiteur électronique (1) de coûts de chauffage selon la revendication 2, dans lequel la piste conductrice (22) présente une grande surface à l'emplacement de sa liaison au premier élément (11) thermiquement conducteur et élastiquement déformable.

8. Répartiteur électronique (1) de coûts de chauffage selon les revendications 2 ou 7, dans lequel au moins certaines parties de la piste conductrice (22) forment des méandres de manière à découpler thermiquement la sonde (6) de température de corps de chauffe et la sonde (5) de température d'air du local.

9. Répartiteur électronique (1) de coûts de chauffage selon l'une des revendications 1 à 9, dans lequel la carte de circuit (4) présente au moins une interruption (23) qui découple thermiquement la sonde (6) de température de corps de chauffe et la sonde (5) de température d'air du local.

10. Répartiteur électronique (1) de coûts de chauffage selon l'une des revendications 1 à 9, dans lequel un élément thermiquement isolant (14) est disposé entre la sonde (5) de température d'air du local et un côté arrière (3b) qui ferme le boîtier (2) du côté du corps de chauffe.

11. Répartiteur électronique (1) de coûts de chauffage selon la revendication 10, dans lequel la superficie de l'élément thermiquement isolant (14) est plus grande que celle de la sonde (5) de température d'air du local.
